# FASCICULE DE BREVET EUROPEEN

(11) **EP 3 286 491 B1**
(45) Date de publication et mention de la délivrance du brevet: **10.07.2019**
(21) Numéro de dépôt: 16722278.5
(22) Date de dépôt: 31.03.2016
(51) Int. Cl.: F21K 9/00, F21Y 115/10, F21Y 103/10, H01L 25/075

(54) **DISPOSITIF D'ÉCLAIRAGE À FILAMENTS LED**
BELEUCHTUNGSVORRICHTUNG MIT LED-FILAMENTEN
LIGHTING DEVICE WITH LED FILAMENTS

(30) Priorité: 08.04.2015 FR 1553011
(43) Date de publication de la demande: 28.02.2018
(73) Titulaire: Led-Ner, 13470 Carnoux en Provence (FR)
(72) Inventeur: PETTMANN, Marc, 13470 Carnoux en Provence (FR)
(74) Mandataire: Chevalier, Renaud Philippe
(86) Numéro de dépôt international: PCT/FR2016/050732
(87) Numéro de publication internationale: WO 2016/162616

(56) Documents cités:
- EP-A2- 2 434 201
- CN-A- 104 110 632
- CN-U- 204 099 964
- US-A1- 2011 273 863
- US-A1- 2013 141 892
- US-A1- 2014 369 036
- US-A1- 2014 375 201

## Description

La présente invention se rapporte à un dispositif d'éclairage, et plus spécifiquement à un dispositif d'éclairage comportant des sources lumineuses du type filament LED.

La présente invention trouve une application privilégiée, mais non limitative, dans le domaine des éclairages de vitrines et d'étagères de boutiques, ainsi que le domaine de l'éclairage dans le secteur de l'hôtellerie et de la restauration. L'invention trouve également des applications pour des lustres ou luminaires de créateurs, ainsi que pour des utilisations en extérieur et en environnement humide voire sous-marin, comme par exemple dans le secteur du nautisme ou de l'architecture extérieure.

Dans ces différents domaines, et plus particulièrement dans celui des éclairages de vitrines et d'étagères de boutiques, il est important de fournir un éclairage à très haute qualité de lumière, qui se traduit par un indice IRC (indice de rendu de couleurs) élevé, c'est-à-dire au moins supérieur à 90.

L'invention se propose donc d'exploiter comme sources lumineuses des filaments à LED.

Les filaments LED sont connus de la demande de brevet US 2014/0369036 A1 déposée par la Société Shenzen Runlite Technology Co., Ltd. Ces filaments LED sont également commercialisés par cette même Société sous la référence « LED FILAMENT », et en particulier sous les codes produit FSS1-JG-CEEF-D0, FSS1-JG-NBFF-D0, FSS1-JG-WJDF-D0, FSS1-JG-WIDF-D0, FSQ1-JG-CEAF-D0, FSQ1-JG-WIAF-D0 et FSQ1-JG-WELJ-D0.

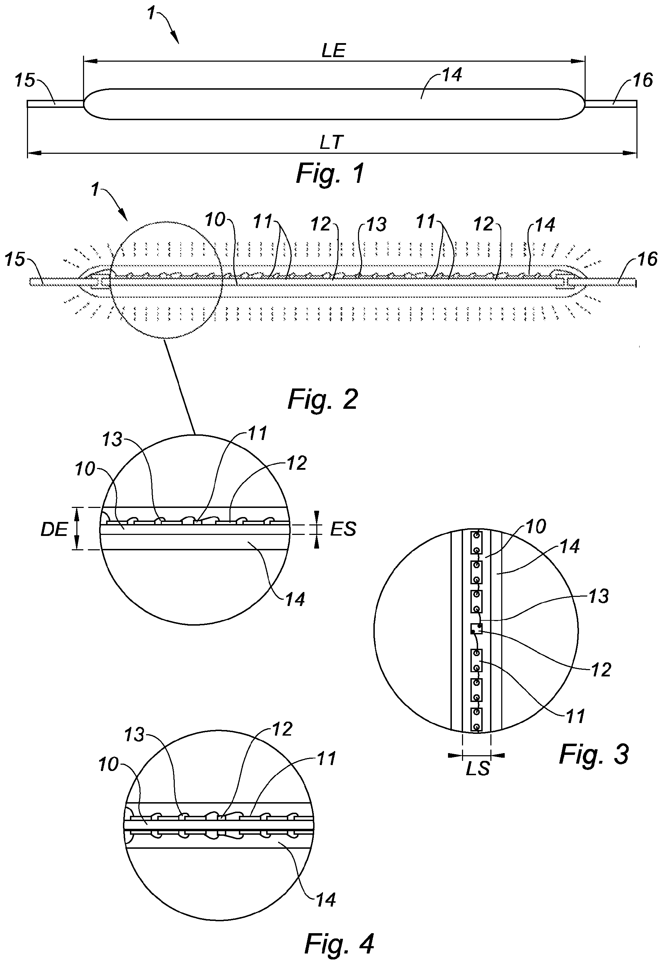

En référence aux figures 1 à 4, un filament LED 1 comprend un substrat 10 se présentant sous la forme d'une barre ou tige plate allongée, une pluralité de diodes électroluminescentes bleues 11 et rouges 12 régulièrement distribuées en ligne sur le substrat 10, ces diodes 11, 12 étant connectées de manière séquentielle les unes à la suite des autres et en série au moyen de fils électriques 13. Le filament LED comprend en outre une enveloppe 14 surmoulée autour des diodes 11, 12 et du substrat 10. Les deux extrémités opposées du substrat sont pourvues de deux électrodes 15, 16 métalliques formant respectivement l'anode et la cathode du filament LED 1, les électrodes 15, 16 étant fixées sur le substrat 10, dans le prolongement de ce dernier, et étant respectivement connectées électriquement aux première et dernière diodes placées sur le substrat 10 au moyen de fils électriques correspondant. Les électrodes 15, 16 dépassent de l'enveloppe 14.

Comme visible sur la figure 2, les diodes 11, 12 peuvent être réparties uniquement sur une face latérale du substrat 10. En variante, et comme visible sur la figure 4, les diodes 11, 12 peuvent être réparties selon deux lignes sur les deux faces latérales opposées du substrat 10.

Le substrat 10 est par exemple réalisé dans un matériau transparent au rayonnement des diodes 11, 12, afin de favoriser un éclairage à 360° autour de l'enveloppe 14, tel qu'un matériau céramique ou plastique.

L'enveloppe 14, placée sur toute la périphérie du substrat 10, forme une couche protectrice qui est réalisée dans un gel ou matériau colloïdale transparent contenant des particules fluorescentes, et notamment des particules de phosphore.

La longueur totale LT du filament LED 1 est classiquement compris entre 10 et 150 millimètres, le substrat 10 présente une largeur LS comprise entre 0,5 et 2 millimètres et une épaisseur ES comprise entre 0,1 et 1 millimètres, l'enveloppe 14 est de section transversale sensiblement circulaire selon un diamètre DE compris entre 1 et 5 millimètres.

Il est connu, notamment des documents CN104406068, CN104377194 et CN204201571, d'employer de tels filaments LED à l'intérieur d'une ampoule à culot, en remplacement d'un filament à incandescence. Pour ce faire, les filaments LED sont disposés côte à côte à l'intérieur du bulbe d'ampoule, et connectés respectivement au culot et au plot central de l'ampoule.

Cependant, cette utilisation des filaments LED présente plusieurs inconvénients, dont le premier est que les bulbes sont généralement de grandes dimensions et aux caractéristiques géométriques et dimensionnelles figées, limitant leurs intégrations dans des vitrines et étagères de boutiques du fait d'un encombrement excessif. En outre, ces ampoules à filaments LED ne sont pas étanches, et leurs étanchéifications est souvent très complexe voire non réalisable.

Il est en outre connu du document US 2014/375201 de disposer, au sein d'un bulbe d'ampoule, un filament LED à l'intérieur d'un tube transparent de convection de la chaleur, voire de disposer plusieurs filaments LED connectés en série et entourés par des tubes respectifs qui sont rapprochés à leurs extrémités. Cette disposition est sans doute adaptée pour une ampoule, mais est complètement inadaptée pour réaliser un dispositif d'éclairage linéaire miniature et modulable.

Le document US 2013/141892 propose de connecter plusieurs filaments LED en série et de les disposer à l'intérieur d'un tube transparent. Cependant, cette connexion en série est inadaptée pour un fonctionnement stable et durable, en particlier en cas de défaillance d'une diode au sein d'un filament LED.

La présente invention a pour but de résoudre en tout ou partie les inconvénients susmentionnés, en proposant un dispositif d'éclairage à filaments LED qui présente un encombrement réduit, et en particulier un dispositif d'éclairage linéaire miniature et modulable.

A cet effet, elle propose un dispositif d'éclairage comprenant plusieurs filaments LED disposés à l'intérieur d'un contenant externe au moins partiellement transparent et connectés à des bornes de sortie anode et cathode disposées à l'extérieur du contenant externe, chaque filament LED comprenant un substrat longiligne, une pluralité de diodes électroluminescentes régulièrement distribuées en ligne sur le substrat, lesdites diodes étant connectées de manière séquentielle les unes à la suite des autres et en série, une enveloppe surmoulée autour des diodes et du substrat, et deux électrodes métalliques formant respectivement l'anode et la cathode du filament LED dépassant de ladite enveloppe, lesdites électrodes étant fixées respectivement aux deux extrémités opposées du substrat et étant respectivement connectées électriquement aux première et dernière diodes placées sur le substrat, ledit dispositif d'éclairage étant remarquable en ce que ledit contenant externe forme une pièce creuse et longiligne pourvue de deux extrémités opposées, et en ce que les filaments LED sont répartis selon au moins une ligne d'éclairage, où la ou chaque ligne d'éclairage comprend plusieurs filaments LED disposés en alignement les uns à la suite des autres et connectées en parallèle de sorte que leurs anodes sont connectées à la borne de sortie anode et leurs cathodes sont connectées à la borne de sortie cathode.

Ainsi, l'invention propose d'employer des filaments LED, connus notamment de la demande de brevet US 2014/0369036 A1, en les alignant à l'intérieur d'un contenant longiligne, offrant ainsi un encombrement particulièrement limité. En effet, en profitant de la forme longiligne des filaments LED et de leurs épaisseurs/diamètres particulièrement faibles (moins de 5 millimètres, voire moins de 2 millimètres), l'invention permet d'obtenir un éclairage sur 360°, tout en offrant la possibilité de proposer des dispositifs d'éclairage linéaire et de la longueur souhaitée.

A titre facultatif, chaque filament LED peut comprendre une pluralité de diodes électroluminescentes bleues et rouges régulièrement distribuées, et l'enveloppe est réalisée dans un gel ou matériau colloïdale transparent contenant des particules fluorescentes, et notamment des particules de phosphore.

Selon l'invention, le dispositif d'éclairage comprend en outre au moins un réflecteur opaque, présentant une surface interne réfléchissante, disposé sur un pourtour du contenant externe et présentant une fente longitudinale prévue pour le passage de la lumière émise par les filaments LED.

Un tel réflecteur permet de laisser passer, par sa fente longitudinale, une partie du flux lumineux ; la largeur de la fente longitudinale est adaptée suivant la directivité ou l'angle d'émission souhaité pour l'éclairage.

Il est bien entendu envisageable de prévoir un ou plusieurs réflecteurs sur le contenant externe, plus ou moins longs et plus ou moins proches. Avec l'emploi de plusieurs réflecteurs, il est possible, de par l'orientation indépendante des réflecteurs, de focaliser différentes zones de l'espace éclairé.

La surface interne réfléchissante peut être une surface interne blanche neutre ou une surface interne blanche pigmentée d'au moins une couleur.

Selon une caractéristique, le ou chaque réflecteur présente une section transversale en arc de cercle dont le centre est localisé sensiblement sur une ligne d'éclairage, de sorte qu'il forme, en situation d'éclairage, une cavité résonnante qui renvoie dans l'enveloppe d'au moins un filament LED de multiples fois le flux d'éclairage.

Dans les filaments LED, il est connu d'employer une enveloppe composée d'un gel contenant des particules fluorescentes, et notamment des particules de phosphore.

Pour rappel, les filaments LED comprennent des diodes électroluminescentes bleues. Or, une seule partie de l'émission bleue des filaments LED est absorbée par les particules fluorescentes, de sorte que se superposent au moins deux émissions en sortie du filament LED.

La Demanderesse a observé que, lorsque l'on positionne, autour d'un filament LED, un tel réflecteur en forme d'arche centrée sur les filaments LED et ayant un revêtement interne réfléchissant, le réflecteur renvoie tout le spectre émis par le filament LED à travers l'enveloppe du filament LED qui sera à nouveau excité par les raies bleues. Ainsi, la lumière de sortie devient moins blanche, et ainsi de suite réflexion après réflexion.

Autrement dit, le réflecteur forme une cavité résonnante qui renvoie dans l'enveloppe d'au moins un filament LED de multiples fois le flux efficace (spectre bleu) émis à travers celui-ci. On augmente donc artificiellement le rendement des particules fluorescentes en limitant l'énergie spectrale bleue sortant de la fente longitudinale du réflecteur. L'effet induit inattendu est donc un réchauffement de la lumière émise, une uniformisation de la colorimétrie et un filtrage très efficace du rayonnement bleu.

Selon le revêtement interne réfléchissant du réflecteur, on obtient différentes températures de couleur résultantes. Ainsi, par l'association de plusieurs réflecteurs plus ou moins blancs, il est possible d'influer sur la température de couleur résultante par zone avec le même dispositif d'éclairage.

Selon une autre caractéristique, le ou chaque réflecteur s'étend sur un secteur d'angle au moins supérieur à 200°.

Avec un tel secteur d'angle, l'effet de résonnance observée ci-dessus est amplifié. A titre d'exemple, le ou chaque réflecteur s'étend sur un secteur d'angle compris entre 240 et 330°, offrant ainsi un angle d'ouverture de la fente compris entre 30 et 120°.

Cependant, il est bien entendu envisageable que le ou chaque réflecteur s'étende sur un secteur d'angle inférieur à 200°, voire même inférieur à 180°.

Dans une première réalisation du réflecteur, le réflecteur se présente sous la forme d'un élément réfléchissant monté autour du contenant externe c'est-à-dire sur un pourtour externe du contenant externe, ou monté à l'intérieur du contenant externe c'est-à-dire sur un pourtour interne du contenant externe.

Lorsque l'élément réfléchissant est monté autour du contenant externe, il peut être monté et maintenu par clipsage sur le contenant externe. Il est bien entendu envisageable de maintenir le réflecteur sur le contenant externe par collage, ou bien au moyen d'un système de fixation rapporté.

Dans une seconde réalisation du réflecteur, le réflecteur se présente sous la forme d'une couche réfléchissante déposée sur un pourtour externe du contenant externe ou sur un pourtour interne du contenant externe.

Avantageusement, le dispositif d'éclairage comprend en outre une optique disposée au moins partiellement en regard de la fente du réflecteur, de sorte que le flux de lumière sortant de ladite fente passe par cette optique.

Dans une première réalisation de l'optique, un élément d'optique est monté sur le contenant externe, cet élément d'optique présentant une section transversale en arc de cercle et comprenant deux parties latérales verrouillées sur le contenant externe (notamment par clipsage) et une partie centrale formant l'optique disposée au moins partiellement en regard de la fente du réflecteur.

Dans une seconde réalisation de l'optique, l'optique est réalisée sous la forme d'un revêtement rapporté sur le contenant externe ou d'un traitement réalisé dans la matière constitutive du contenant externe, notamment par gravure.

Dans une réalisation particulière, l'optique est :
- une optique de focalisation, convergence ou divergence du flux de lumière sortant de la fente du réflecteur, ou
- une optique de filtrage du flux de lumière sortant de la fente du réflecteur de type filtrage opalisant, opalescent, sablé, micro lenticullaire ou micro prismique.

Dans une premier mode de réalisation, la ou chaque ligne d'éclairage comprend :
- des filaments LED alignés ;
- un premier fil électriquement conducteur connecté d'une part à la borne de sortie cathode et d'autre part aux cathodes des filaments LED ; et
- un second fil électriquement conducteur connecté d'une part à la borne de sortie anode et d'autre part aux anodes des filaments LED ;
où lesdits premier et second fils s'étendent à l'intérieur du contenant externe le long et de part et d'autre des filaments LED alignés de la ligne d'éclairage.

Ce premier mode de réalisation est particulièrement avantageux pour réduire l'encombrement transversal (ou épaisseur ou diamètre) du dispositif d'éclairage linéaire. En effet, les deux fils, notamment du type fil de cuivre, sont particulièrement fins et vont permettre de relier en parallèle tous les filaments LED d'une même ligne d'éclairage, tout en ayant que peu d'influence sur l'encombrement transversal du dispositif d'éclairage. En outre, ces fils vont permettre d'assurer la cohésion mécanique de la ligne d'éclairage, et sont trop fins pour gêner la diffusion de la lumière à 360°.

Il est en outre à noter que les fils peuvent totalement être à nu ou bien être au moins partiellement isolé, notamment en employant des fils émaillés.

Dans une réalisation particulière de ce premier mode de réalisation, pour la ou chaque ligne d'éclairage, les filaments LED sont positionnés tête-bêche, avec la cathode d'un filament LED placée en face de la cathode d'un filament LED adjacent et avec l'anode d'un filament LED placée en face de l'anode d'un filament LED adjacent.

Ainsi, dans une même ligne d'éclairage, deux filaments LED adjacents sont orientés selon des sens anode-cathode opposés. Ce positionnement tête-bêche est particulièrement pratique pour le câblage des filaments LED avec les deux fils.

Il est bien entendu envisageable, en variante, que tous les filaments LED soient positionnés dans le même sens anode-cathode, dans la même ligne d'éclairage.

Selon une caractéristique, pour la ou chaque ligne d'éclairage, la cathode d'un filament LED est soudée à la cathode d'un filament LED adjacent et l'anode d'un filament LED est soudée à l'anode d'un filament LED adjacent, et le premier fil est connecté aux cathodes des filaments LED par des points de soudure, et le second fil est connecté aux anodes des filaments LED par des points de soudure.

Les connexions par soudure participent également de la miniaturisation du dispositif d'éclairage, tout en offrant tenue et durabilité.

Selon une autre caractéristique, pour la ou chaque ligne d'éclairage, la cathode d'un filament LED est reliée à la cathode d'un filament LED adjacent via une résistance électrique, et l'anode d'un filament LED est reliée à l'anode d'un filament LED adjacent via une résistance électrique.

Avec plusieurs filaments LED alignés et connectés électriquement en parallèle, il est envisageable d'observer des différences de tension de passage, de l'ordre du centivolt, entre les filaments LED, se traduisant par des différences substantielles de température entre les filaments LED, notamment de l'ordre d'une dizaine à une vingtaine de degrés.

En utilisant des résistances, de préférence des résistances de l'ordre de quelques ohms (entre 1 et 20 ohms par exemple), entre les filaments LED et éventuellement entre les filaments LED et les fils conducteurs, les résistances absorberaient les différences de tension de passage, et équilibreraient l'ensemble pour garantir une température uniforme entre les filaments LED.

Avantageusement, pour la ou chaque ligne d'éclairage, le premier fil est maintenu écarté des anodes des filaments LED au moyen d'éléments séparateurs en matériau isolant électriquement, et le second fil est maintenu écarté des cathodes des filaments LED au moyen d'éléments séparateurs en matériau isolant électriquement.

Ces éléments séparateurs vont garantir d'éviter des courts circuits, surtout en cas de mouvement du dispositif d'éclairage, tout en consolidant mécaniquement la ligne d'éclairage, en offrant un maintien mécanique localisé de l'ensemble filaments LED et fils.

Dans une réalisation particulière, les éléments séparateurs sont constitués de points de colle ou de silicone.

Ces points de colle ou de silicone sont déposés liquide, puis se durcissent rapidement pour assurer la fonction de séparation, tout en offrant une cohésion qui va maintenir en place les fils.

Dans un second mode de réalisation, la ou chaque ligne d'éclairage comprend un support longiligne, de préférence transparent, présentant sur sa surface au moins un circuit imprimé qui assure la connexion entre la borne de sortie cathode et les cathodes des filaments LED, et également la connexion entre la borne de sortie anode et les anodes des filaments LED.

Dans ce second mode de réalisation, un support avec circuit imprimé est employé, en lieu et place des deux fils décrits pour le premier mode de réalisation. Cette solution avec support, rigide ou souple, transparent ou non, permet d'offrir un support stable mécaniquement pour les filaments LED.

Selon une possibilité de l'invention, le dispositif d'éclairage comprend au moins deux lignes d'éclairage en décalage longitudinal de sorte que les filaments LED d'une ligne d'éclairage sont placés en chevauchement vis-à-vis de deux filaments LED d'une autre ligne d'éclairage.

Grâce à ce chevauchement d'au moins deux lignes d'éclairage, le dispositif d'éclairage va certes gagner en épaisseur, mais il permettra de ne pas avoir de zones d'ombres entre les filaments LED, offrant ainsi un éclairage continu sur toute la longueur des lignes d'éclairage.

Dans une première réalisation du contenant externe, le contenant externe est constitué d'un tube creux rigide et transparent, notamment de section transversale circulaire, recevant intégralement la ou les lignes d'éclairage.

Dans cette réalisation, le dispositif d'éclairage est figé dans une conformation linéaire.

Dans une seconde réalisation du contenant externe, le contenant externe est constitué de plusieurs tronçons tubulaires creux rigides et transparents, ces tronçons tubulaires étant joints bout à bout par des ponts élastiquement déformable, où le dispositif d'éclairage comprend une unique ligne d'éclairage, et le contenant externe intègre autant de tronçons tubulaires que la ligne d'éclairage comprend de filaments LED, chaque tronçon tubulaire entourant un unique filament LED, chaque tronçon tubulaire supportant à ses extrémités respectives des bornes de connexion entre les cathodes et les anodes des filaments LED qui sont entourées par les ponts.

Dans cette réalisation, le dispositif d'éclairage peut être plus ou moins plié ou courbé au niveau du ou des ponts élastiquement déformable, permettant ainsi au dispositif d'éclairage de suivre une ligne incurvée ou courbée.

De manière avantageuse, à l'intérieur de chaque tronçon tubulaire, sont disposés :
- un fil dit de cathode électriquement conducteur qui est connecté d'une part à la cathode du filament LED et d'autre part à deux bornes de connexion dites de cathode disposées aux deux extrémités opposées dudit tronçon tubulaire ; et
- un fil dit d'anode électriquement conducteur qui est connecté d'une part à l'anode du filament LED et d'autre part à deux bornes de connexion dites d'anode disposées aux deux extrémités opposées dudit tronçon tubulaire ;
où la borne de connexion anode dépassant d'un tronçon tubulaire est connectée à la borne de connexion anode dépassant d'un tronçon tubulaire adjacent, et la borne de connexion cathode dépassant d'un tronçon tubulaire est connectée à la borne de connexion cathode dépassant d'un tronçon tubulaire adjacent.

Selon une possibilité de l'invention, le ou chaque pont élastiquement déformable est constitué soit d'un joint souple, notamment en silicone, noyé en partie à l'intérieur des extrémités ouvertes en regard de deux tronçons tubulaires adjacents, soit d'un manchon souple monté en partie autour des extrémités en regard de deux tronçons tubulaires adjacents.

L'invention se rapporte également à une installation d'éclairage comprenant un chaînage d'au moins deux dispositifs d'éclairage conformes à l'invention et joints bout à bout, dans laquelle chaque dispositif d'éclairage comprend deux bornes de sortie anode interconnectées et disposées aux deux extrémités respectives du contenant externe et deux bornes de sortie cathode interconnectées et disposées aux deux extrémités respectives du contenant externe, où les dispositifs d'éclairage sont connectés électriquement en parallèle avec une borne de sortie anode et une borne de sorte cathode d'un dispositif d'éclairage connectées respectivement à une borne de sortie anode et une borne de sorte cathode d'un dispositif d'éclairage adjacent.

Ainsi, cette installation d'éclairage comprend un chaînage de plusieurs dispositifs d'éclairage indépendants et connectés électriquement en parallèle, autrement dit comprend plusieurs dispositifs d'éclairage disposés les uns à la suite des autres en reliant mécaniquement et bout à bout les extrémités des contenant externes.

De la sorte, il est possible de ne pas aligner les dispositifs d'éclairage et de les incliner plus ou moins l'un par rapport à l'autre, pour permettre d'obtenir une rampe d'éclairage selon une ligne incurvée.

De manière avantageuse, une extrémité du contenant externe d'au moins un dispositif d'éclairage est jointe à une extrémité du contenant externe d'au moins un dispositif d'éclairage adjacent au moyen d'une élément de jonction souple qui enveloppe les bornes de sortie concernées des deux dits dispositifs d'éclairage adjacents.

L'élément de jonction souple permet d'assurer l'étanchéité, tout en offrant la souplesse nécessaire pour tolérer une inclinaison entre deux dispositifs d'éclairage adjacents.

D'autres caractéristiques et avantages de la présente invention apparaîtront à la lecture de la description détaillée ci-après, d'un exemple de mise en oeuvre non limitatif, faite en référence aux figures annexées dans lesquelles :
- la figure 1, déjà décrite, est une vue schématique de côté d'un filament LED ;
- la figure 2, déjà décrite, est une vue schématique de côté du filament LED de la figure 1, avec une enveloppe illustrée transparente pour visualiser l'intérieur, un zoom d'une partie du filament LED étant également illustré ;
- la figure 3, déjà décrite, est une vue schématique de dessus de la partie du filament LED faisant l'objet d'un zoom sur la figure 2 ;
- la figure 4, déjà décrite, est une vue schématique équivalente au zoom de la figure 2, pour un autre type de filament LED ;
- la figure 5 est une vue schématique, en perspective, d'une portion d'un dispositif d'éclairage conforme à l'invention, dans lequel le contenant externe est constitué d'un tube creux et comprenant une ligne d'éclairage intégrant deux filaments LED, avec également un zoom d'une partie dudit dispositif d'éclairage ;
- la figure 6 est une vue schématique du câblage employé pour un dispositif d'éclairage conforme à l'invention ;
- les figures 7 à 9 sont des vues schématiques de côté de trois dispositifs d'éclairage conformes à l'invention, dans chacun desquels le contenant externe est constitué d'un tube creux et comprenant chacun une seule ligne d'éclairage ;
- la figure 10 est une vue schématique de côté et incomplète d'un autre dispositif d'éclairage conforme à l'invention, dans lequel le contenant externe est constitué d'un tube creux et comprenant deux lignes d'éclairage, les fils conducteurs et les bornes de sortie n'étant pas illustrés pour des raisons de clarté ;
- la figure 11 est une vue schématique du dispositif d'éclairage de la figure 10, selon le plan de coupe transversal A-A ;
- la figure 12 est une vue schématique, en perspective, d'un dispositif d'éclairage conforme à l'invention, dans lequel le contenant externe est constitué d'un tube creux et intégrant un réflecteur constitué d'un élément réfléchissant monté sur le tube creux ;
- la figure 13 est une vue schématique illustrant le positionnement du réflecteur vis-à-vis des filaments LED dans le dispositif d'éclairage de la figure 12 ;
- la figure 14 est une vue schématique, en perspective, d'un dispositif d'éclairage conforme à l'invention, intégrant un revêtement filtrant sur le pourtour du tube formant le contenant externe transparent ;
- la figure 15 est une vue schématique de côté d'un autre dispositif d'éclairage conforme à l'invention, dans lequel le contenant externe est composé de plusieurs tronçons tubulaires joints par des ponts élastiquement déformable du type joint souple, avec trois zooms sur différentes parties de ce dispositif d'éclairage ;
- la figure 16 est une vue schématique de côté d'un autre dispositif d'éclairage conforme à l'invention, dans lequel le contenant externe est composé de plusieurs tronçons tubulaires joints par des ponts élastiquement déformable du type manchon souple, avec un zoom sur une parties de ce dispositif d'éclairage ;
- la figure 17 est une vue schématique et partielle de face du dispositif d'éclairage de la figure 16, après déformation à angle droit du manchon souple ;
- la figure 18 est une vue schématique en couple transversale du dispositif d'éclairage de la figure 12, intégrant un réflecteur constitué d'un élément réfléchissant monté sur le tube creux ;
- la figure 19 est une vue schématique en couple transversale du dispositif d'éclairage de la figure 18, intégrant en outre un élément d'optique placé sur le tube ;
- la figure 20 est une vue schématique en couple transversale d'un dispositif d'éclairage conforme à l'invention, intégrant un réflecteur constitué d'une couche réfléchissante déposée sur le pourtour externe du tube creux ;
- la figure 21 est une vue schématique en couple transversale du dispositif d'éclairage de la figure 20, intégrant en outre un élément d'optique placé sur le tube ;
- la figure 22 est une vue schématique en couple transversale d'un dispositif d'éclairage conforme à l'invention, intégrant un réflecteur constitué d'une couche réfléchissante déposée sur le pourtour interne du tube creux ; et
- la figure 23 est une vue schématique en couple transversale du dispositif d'éclairage de la figure 20, intégrant en outre un élément d'optique placé sur le tube.

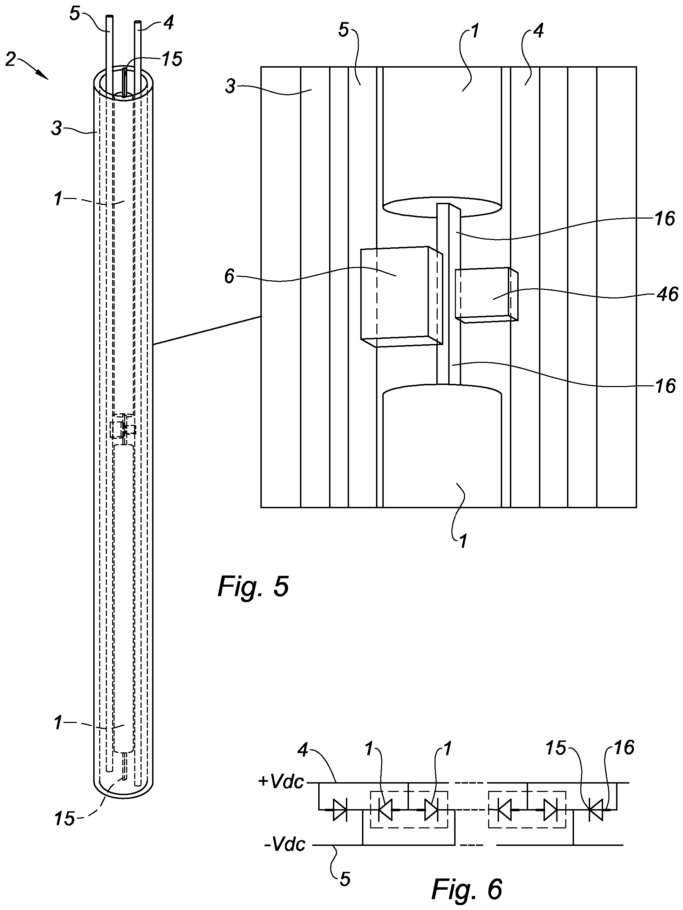

En référence aux figures 5, 7, 8, 9, 10, 11, 12 et 14, un dispositif d'éclairage 2 conforme à l'invention comprend un contenant externe 3 formé d'un tube transparent, de section circulaire, réalisé dans un matériau transparent tel que du verre (notamment en borosilicate) ou un matériau polymère ou plastique. Ce tube 3 forme ainsi une pièce creuse, rigide et longiligne selon un axe longitudinal.

Ce tube 3 présente un diamètre externe compris entre 4 et 10 millimètres, et une épaisseur compris entre 0,5 et 1,5 millimètres. Ce tube 3 présente deux extrémités 31 opposées ouvertes.

Le dispositif d'éclairage 2 comprend également au moins une ligne d'éclairage disposée à l'intérieur du tube 3 et composée d'une succession de plusieurs filaments LED 1 tels que décrits précédemment en référence aux figures 1 à 4.

Pour des raisons de miniaturisation, il est avantageux que les filaments LED 1 présentent une dimension transversale inférieure à 3 millimètres, notamment de l'ordre de 1,8 à 2,5 millimètres ; le diamètre interne du tube 3 étant choisi en fonction des dimensions transversales des filaments LED 1.

Dans une ligne d'éclairage, les filaments LED 1 sont disposés en alignement les uns à la suite des autres selon une direction longitudinale substantiellement parallèle à l'axe longitudinal du tube 3.

Dans les modes de réalisation des figures 5 à 11, pour une ligne d'éclairage, les filaments LED 1 sont positionnés tête-bêche, avec la cathode 16 d'un filament LED 1 placée en face de la cathode 16 d'un filament LED 1 adjacent et avec l'anode 15 d'un filament LED 1 placée en face de l'anode 15 d'un filament LED 1 adjacent.

Plus précisément, au sein d'une même ligne d'éclairage, la cathode 16 d'un filament LED 1 est soudée à la cathode 16 d'un filament LED 1 adjacent et l'anode 15 d'un filament LED 1 est soudée à l'anode 15 d'un filament LED 1 adjacent. Il est envisageable de prévoir une résistance (non illustrée) de quelques ohms entre les cathodes 16 de deux filaments LED 1 adjacents, et entre les anodes 15 de deux filaments LED 1 adjacents.

En outre, le dispositif d'éclairage 2 comprend :
- un premier fil 4 électriquement conducteur, du type fil métallique nu ou fil isolé (par exemple fil métallique émaillé), qui est connecté par soudure aux cathodes 16 des différents filaments LED 1 (le zoom de la figure 5 illustrant un point de soudure 46) ; et
- un second fil 5 électriquement conducteur, du type fil métallique nu ou fil isolé (par exemple fil métallique émaillé), qui est connecté par soudure aux anodes 15 des différents filaments LED 1.

Ces fils 4, 5 s'étendent à l'intérieur du tube 3, le long des filaments LED 1, et s'étendent respectivement de part et d'autre des filaments LED 1 alignés de la ligne d'éclairage.

Les fils 4, 5 sont respectivement connectés à au moins une borne de sortie cathode 40 et à au moins une borne de sortie anode 50.

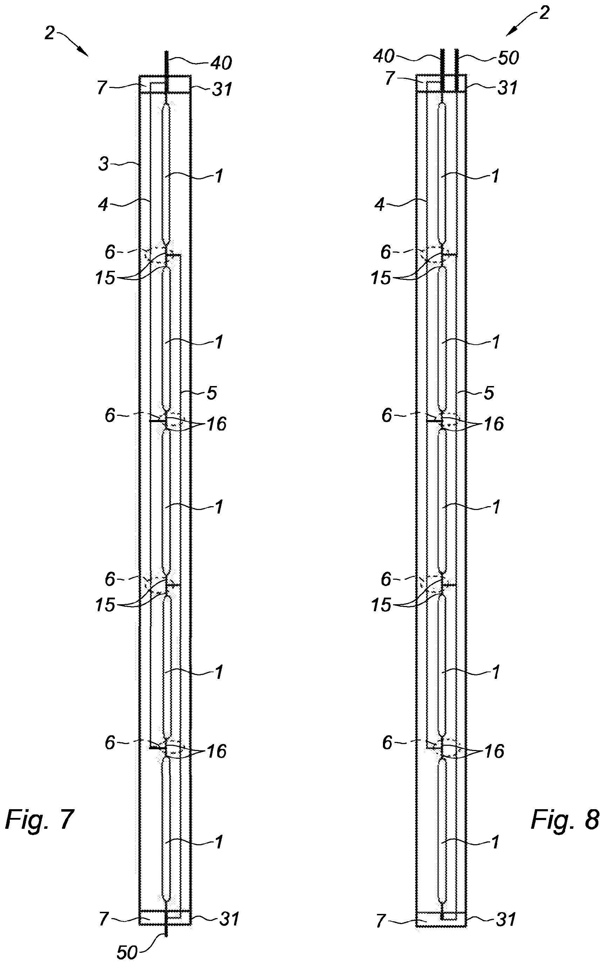

Dans le mode de réalisation de la figure 7, le dispositif d'éclairage 2 comprend une borne de sortie cathode 40 à une extrémité 31 du tube 3, et une borne de sortie anode 50 à l'autre extrémité 31 du tube 3.

Dans le mode de réalisation de la figure 8, le dispositif d'éclairage 2 comprend une borne de sortie cathode 40 à une extrémité 31 du tube 3, et une borne de sortie anode 50 à la même extrémité 31 du tube 3.

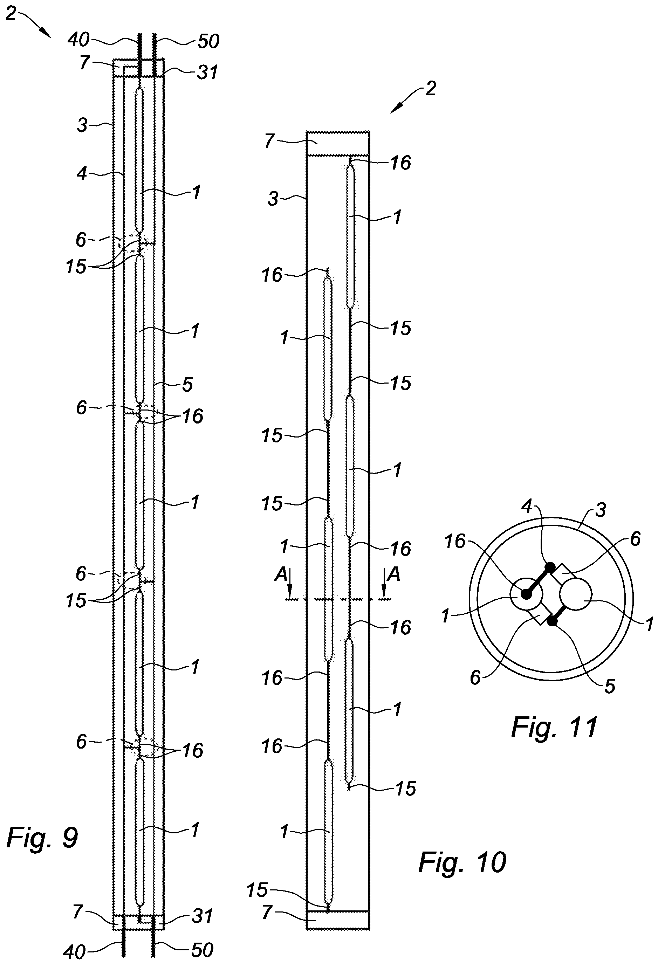

Dans le mode de réalisation de la figure 9, le dispositif d'éclairage 2 comprend une borne de sortie cathode 40 et une borne de sortie anode 50 à une extrémité 31 du tube 3, et également une autre borne de sortie cathode 40 et une autre borne de sortie anode 50 à l'autre extrémité 31 du tube 3.

Au niveau des anodes 15 des filaments LED 1, le premier fil 4 est maintenu écarté des anodes 15 des filaments LED 1 au moyen d'éléments séparateurs 6 en matériau isolant électriquement, tel que des points de colle ou de silicone. De même, au niveau des cathodes 16 des filaments LED 1, le second fil 5 est maintenu écarté des cathodes 16 des filaments LED 1 au moyen d'éléments séparateurs 6 en matériau isolant électriquement, tel que des points de colle ou de silicone.

Des bouchons 7 en matériau isolant, tel que des bouchons en silicone ou dans un autre matériau plastique, sont placés aux extrémités 31 du tube 3, et plus précisément à l'intérieur du tube 3. Les fils 4, 5 sont ainsi connectés aux bornes de sortie 40, 50 concernées à travers ces bouchons 7 qui vont participer au maintien stable des fils 4, 5 et des bornes de sortie 40, 50 partiellement noyés dans les bouchons 7.

Dans les modes de réalisation des figures 5, 7, 8, 9, 12 et 14, le dispositif d'éclairage 2 comprend une seule ligne d'éclairage composée de filaments LED 1 en ligne.

Comme visible sur la figure 9, il est envisageable que le dispositif d'éclairage 2 comprenne plusieurs lignes d'éclairage, autrement dit plusieurs séries de filaments LED 1 en ligne, où les filaments LED 1 d'une ligne d'éclairage sont décalés longitudinalement vis-à-vis des filaments LED d'une autre ligne d'éclairage, de sorte que les filaments LED 1 d'une ligne d'éclairage sont placés en chevauchement vis-à-vis de deux filaments LED 1 d'une autre ligne d'éclairage.

Comme visible sur la figure 10, dans le cas de plusieurs lignes d'éclairage, les cathodes 16 des filaments LED 1 sont toutes connectées (notamment par soudure) au même premier fil 4 et maintenues espacées du second fil 5 par des éléments séparateurs 6, et les anodes 15 des filaments LED 1 sont toutes connectées (notamment par soudure) au même second fil 5 et maintenues espacées du premier fil 4 par des éléments séparateurs 6.

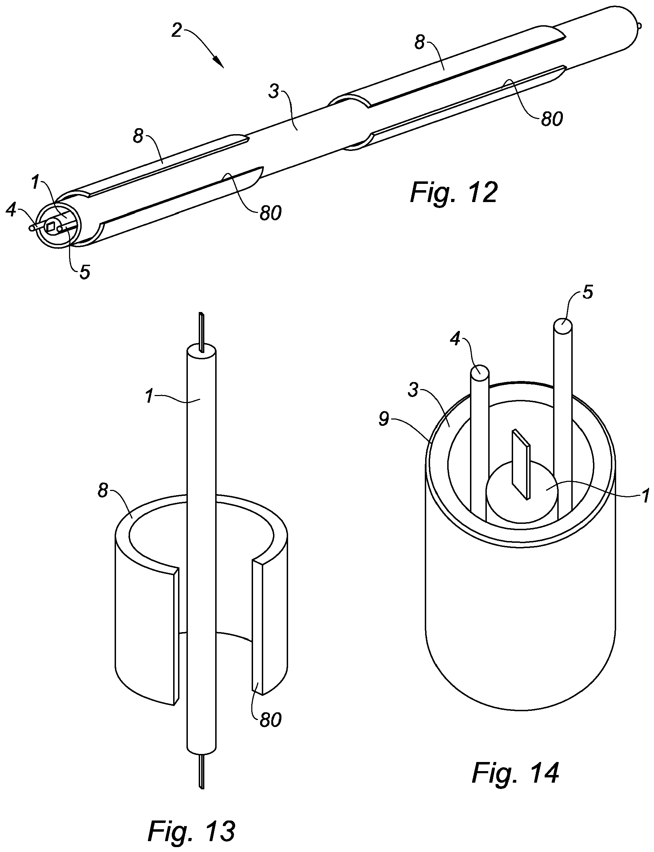

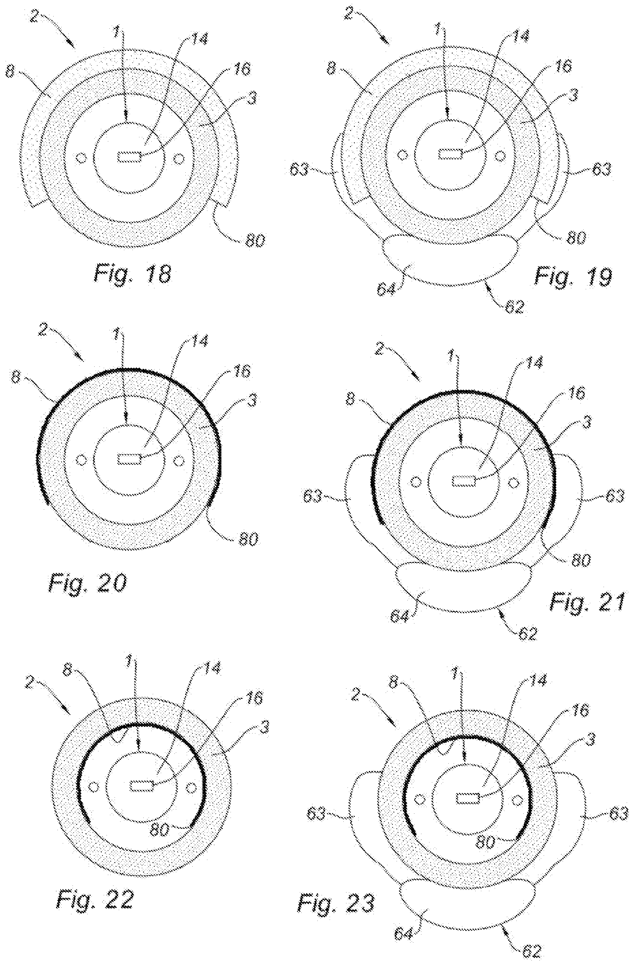

Comme visible sur la figure 12, ainsi que sur les figures 18 et 19, il est envisageable de prévoir un ou plusieurs réflecteurs 8 opaques montés autour du tube 3, plus précisément sur le pourtour externe (ou sur la surface périphérique externe) du tube 3. Comme visible sur la figure 13, le ou chaque réflecteur 8 se présente sous la forme d'un élément réfléchissant (souple ou rigide) présentant une section transversale en arc de cercle dont le centre est localisé sensiblement sur une ligne d'éclairage, autrement dit sur un filament LED 1. Le ou chaque réflecteur 8 présente une fente longitudinale 80 prévue pour le passage de la lumière émise par les filaments LED 1.

Le ou chaque réflecteur 8 s'étend notamment sur un secteur d'angle compris entre 240 et 330°, offrant ainsi un angle d'ouverture de la fente compris entre 30 et 120°. Il est envisageable qu'un réflecteur 8 s'étende sur toute la longueur du tube 3, voire sur au moins 90% de la longueur du tube 3.

Le ou chaque réflecteur 8 est plaqué sur le pourtour externe du tube 3, et est maintenu en place par clipsage, autorisant le coulissement et le pivotement du réflecteur 8 sur le tube 3 ; d'autres moyens de fixation du réflecteur 8 sur le tube 3, notamment par collage, étant envisageables.

Le réflecteur 8 comporte un revêtement interne réfléchissant neutre blanc ; les caractéristiques de ce revêtement interne pouvant être adaptées pour obtenir la colorimétrie souhaitée.

Le positionnement du ou de chaque réflecteur 8 sur une partie d'un tronçon du tube 3 permet par rotation sur 360°, de laisser passer par sa fente 80, une partie du flux lumineux ; la largeur de la fente 80 étant dimensionnée suivant la directivité ou l'angle d'émission de lumière souhaités, et la longueur du réflecteur 8 étant dimensionné selon la taille des zones à éclairer.

Les filaments LED 1 sont basés sur l'interconnection de plusieurs diodes électroluminescentes émettant une lumière bleue, ces diodes électroluminescentes étant recouvertes par un gel contenant des particules fluorescentes, notamment des particules de phospore. Ainsi, avec un tel filament LED, une seule partie de l'émission bleue est absorbée par le phosphore de telle sorte que se superposent deux émissions en sortie du filament LED, donnant l'impression d'une lumière blanche.

Lorsque l'on positionne un réflecteur 8, son revêtement interne réfléchissant renvoie tout le spectre à travers l'enveloppe fluorescente du filament LED, qui sera à nouveau excité par les raies "bleues". La lumière de sortie devient donc moins blanche, et ainsi de suite après plusieurs réflexion sur le réflecteur 8. Autrement dit, le réflecteur 8 sert de cavité résonnante qui renvoie dans le phosphore de multiples fois le flux efficace (spectre bleu) émis à travers celui-ci. On augmente donc artificiellement le rendement du phosphore en limitant l'énergie spectrale bleue sortant de la fente 80 du réflecteur 8. L'effet induit étant un réchauffement de la lumière émise, une uniformisation de la colorimétrie et un filtrage très efficace du rayonnement bleu.

Dans une première variante non illustrée du réflecteur, le ou chaque réflecteur 8 est monté à l'intérieur du tube 3, plus précisément sur le pourtour interne (ou sur la surface périphérique interne) du tube 3. Le ou chaque réflecteur 8 se présente alors sous la forme d'un élément réfléchissant (souple ou rigide) présentant une section transversale en arc de cercle dont le centre est localisé sensiblement sur un filament LED 1. Le ou chaque réflecteur 8 est glissé à l'intérieur du tube 3, et est maintenu en place de par sa forme arquée, avec la possibilité d'un coulissement et d'un pivotement du réflecteur 8 dans le tube 3.

Dans une deuxième variante du réflecteur illustré sur les figures 20 et 21, le réflecteur 8 est réalisé sous la forme d'une couche réfléchissante déposée sur le pourtour externe (ou sur la surface périphérique externe) du tube 3, et plus spécifiquement déposée sur une section transversale en arc de cercle du tube 3 de longueur prédéfinie. Le réflecteur 8 formée d'une telle couche réfléchissante externe présente ainsi une fente longitudinale 80 prévue pour le passage de la lumière émise par les filaments LED 1, et s'étend notamment sur un secteur d'angle compris entre 240 et 330°, offrant ainsi un angle d'ouverture de la fente 80 compris entre 30 et 120°. Cette couche réfléchissante externe peut par exemple être déposée par peinture ou par électro-évaporation.

Dans une troisième variante du réflecteur illustré sur les figures 22 et 23, le réflecteur 8 est réalisé sous la forme d'une couche réfléchissante déposée sur le pourtour interne (ou sur la surface périphérique interne) du tube 3, et plus spécifiquement déposée sur une section transversale en arc de cercle du tube 3 de longueur prédéfinie. Le réflecteur 8 formée d'une telle couche réfléchissante interne présente ainsi une fente longitudinale 80 prévue pour le passage de la lumière émise par les filaments LED 1, et s'étend notamment sur un secteur d'angle compris entre 240 et 330°, offrant ainsi un angle d'ouverture de la fente 80 compris entre 30 et 120°. Cette couche réfléchissante interne peut par exemple être déposée par peinture ou par électro-évaporation.

Comme visible sur les figures 19, 21 et 23, il est envisageable de monter un élément d'optique 62 sur le tube 3 qui sert par exemple à faire converger ou diverger le flux de lumière sortant de la fente 80 d'un réflecteur 8. Cet élément d'optique 62 présente une section transversale en arc de cercle et comprend deux parties latérales 63 qui viennent se clipser sur le tube 8, éventuellement par-dessus le réflecteur 8 lorsque le réflecteur 8 est disposé sur le pourtour externe du tube 3, et une partie centrale 64 formant une optique positionnée en regard de la fente 80 du réflecteur 8. Les parties latérales 63 peuvent être en matière translucide dépolie.

La partie centrale 64 peut former une optique de type lentille (convergente ou divergente) et être ainsi réalisée en matière transparente et être de forme adaptée pour une convergence ou une divergence du flux de lumière sortant de la fente 80 du réflecteur 8.

En variante, la partie centrale 64 peut former une optique de type élément opalescent ou opalisant, réalisé dans un matériau translucide qui donne à la lumière un aspect ou une teinte laiteuse, avec des reflets irisés rappelant ceux de l'opale.

A la place de cet élément d'optique 62 rapporté sur le tube 3, il est envisageable de graver directement une optique (par exemple une optique opalisante, focalisante, convergente ou divergente) sur le pourtour externe ou interne du tube 3, sur une bande du tube 3 en correspondance avec la fente 80 du réflecteur 8, de sorte que le flux de lumière sortant de la fente 80 du réflecteur 8 passe par cette optique.

Comme visible sur la figure 14, il est également envisageable de prévoir un revêtement filtrant 9 positionné par collage sur le pourtour externe du tube 3 afin d'améliorer l'homogénéité spectrale du flux. Ce revêtement filtrant 9 est par exemple du type film micro lenticullaire, film à micro prismes ou film Frost. Avec un tel revêtement filtrant 9, la distribution de lumière est de fait un peu plus homogène, par contre l'efficacité lumineuse tend à baisser légèrement. En présence d'un réflecteur 8, un tel revêtement 9 peut être prévu uniquement sur une bande du tube 3 en correspondance avec la fente 80 du réflecteur 8, de sorte que le flux de lumière sortant de la fente 80 du réflecteur 8 passe par ce revêtement filtrant 9.

En variante, il est envisageable d'employer pour le tube 3 un verre opalisé, opalescent ou sablé.

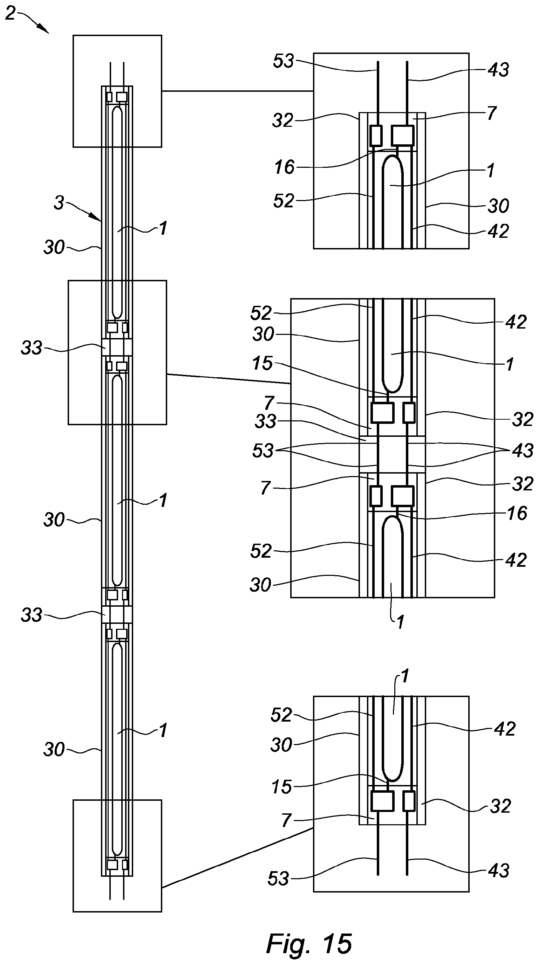

En référence aux figures 15 à 17, un dispositif d'éclairage 2 conforme à l'invention peut également comprendre un contenant externe 3 qui forme une pièce creuse constituée de plusieurs tronçons tubulaires 30 creux rigides et transparents, notamment de section circulaire, ces tronçons tubulaires 30 étant joints bout à bout par des ponts élastiquement déformable 33 qui autorisent l'inclinaison entre deux tronçons tubulaires 30 adjacents.

Les tronçons tubulaires 30 sont réalisés dans un matériau rigide et transparent tel que du verre (notamment en borosilicate) ou un matériau polymère ou plastique. De préférence, les tronçons tubulaires 30 sont identiques dans leurs formes et dimensions.

Dans ce mode de réalisation avec plusieurs tronçons tubulaires 30 :
- chaque tronçon tubulaire 30 présente par exemple un diamètre externe compris entre 4 et 10 millimètres, et une épaisseur compris entre 0,5 et 1,5 millimètres, chaque tronçon tubulaire 30 présentant deux extrémités 32 opposées ouvertes ;
- le dispositif d'éclairage 2 comprend également une unique ligne d'éclairage disposée à l'intérieur des tronçons tubulaires 3 successifs, la ligne d'éclairage étant composée d'une succession de plusieurs filaments LED 1 tels que décrits précédemment en référence aux figures 1 à 4 ;
- le contenant externe 3 intègre autant de tronçons tubulaires 30 que la ligne d'éclairage comprend de filaments LED 1, chaque tronçon tubulaire 30 entourant un unique filament LED 1.

Plus précisément, à l'intérieur de chaque tronçon tubulaire 30, sont disposés :
- un fil dit de cathode 42 électriquement conducteur qui est connecté d'une part à la cathode 16 du filament LED 1 et d'autre part à deux bornes de connexion dites de cathode 43 disposées aux deux extrémités 32 opposées dudit tronçon tubulaire 30 ; et
- un fil dit d'anode 52 électriquement conducteur qui est connecté d'une part à l'anode 15 du filament LED 41 et d'autre part à deux bornes de connexion dites d'anode 53 disposées aux deux extrémités 32 opposées dudit tronçon tubulaire ;
- des bouchons 7 en matériau isolant, tel que des bouchons en silicone ou dans un autre matériau plastique, qui sont placés aux extrémités 32 du tronçon tubulaire 30, et plus précisément à l'intérieur du tronçon tubulaire 30.

La borne de connexion anode 53 dépassant d'un tronçon tubulaire 30 est connectée à la borne de connexion anode 53 dépassant d'un tronçon tubulaire 30 adjacent, soit par soudage soit au moyen d'un fil électrique souple autorisant l'inclinaison entre deux tronçons tubulaires 30 adjacents.

De même, la borne de connexion cathode 43 dépassant d'un tronçon tubulaire 30 est connectée à la borne de connexion cathode 43 dépassant d'un tronçon tubulaire 30 adjacent, soit par soudage soit au moyen d'un fil électrique souple autorisant l'inclinaison entre deux tronçons tubulaires 30 adjacents.

Bien entendu, les bornes de connexion 43, 53 aux extrémités du contenant externe 3 forme des bornes de sortie du dispositif d'éclairage 2.

De plus, les bouchons 7 vont participer au maintien stable des fils 42, 52 et des bornes de connexion 43, 53 qui sont partiellement noyés dans les bouchons 7.

Dans le mode de réalisation de la figure 15, chaque pont élastiquement déformable 33 est constitué d'un joint souple, notamment en matière élastomère tel que du silicone, noyé en partie à l'intérieur des extrémités 32 ouvertes en regard de deux tronçons tubulaires 30 adjacents. Ce joint souple 33 maintient un écartement longitudinal entre les extrémités 32 en regard de deux tronçons tubulaires 30 adjacents. Ce joint souple 33 vient par exemple de matière avec les bouchons 7. Le remplissage avec la matière élastomère peut être effectué par injection dans un moule qui reprend le même diamètre que l'extrémité 32 ouverte ; l'avantage d'un tel remplissage étant qu'il assure une excellente liaison mécanique de l'ensemble car la matière éladtomère adhère sur les côtés des extrémités 32, tout en assurant un positionnement constant des bornes de connexion 43, 53.

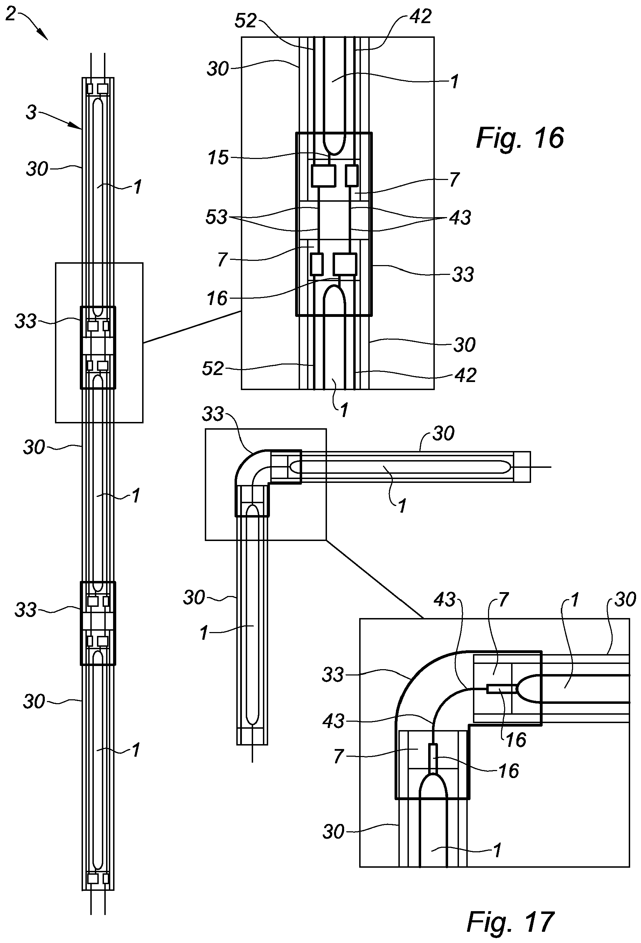

Dans le mode de réalisation des figures 16 et 17, chaque pont élastiquement déformable 33 est constitué d'un manchon souple, notamment en matière élastomère tel que du silicone, monté en partie autour des extrémités 32 en regard de deux tronçons tubulaires adjacents 30.

Comme visible sur la figure 17, il est possible d'incliner un tronçon tubulaire 30 par rapport à un tronçon tubulaire 30 adjacent selon un angle non nul, comme par exemple un angle droit, grâce à la capacité de déformation du pont élastiquement déformable 33 et des bornes de connexion cathode 43 qui forment des pattes pliables.

## Revendications

1. Dispositif d'éclairage (2) comprenant plusieurs filaments LED (1) disposés à l'intérieur d'un contenant externe (3) au moins partiellement transparent et connectés à des bornes de sortie anode et cathode (40, 50 ; 43, 53) disposées à l'extérieur du contenant externe (3), chaque filament LED (1) comprenant un substrat (10) longiligne, une pluralité de diodes électroluminescentes (11, 12) régulièrement distribuées en ligne sur le substrat (10), lesdites diodes (11, 12) étant connectées de manière séquentielle les unes à la suite des autres et en série, une enveloppe (14) surmoulée autour des diodes (11, 12) et du substrat (10), et deux électrodes métalliques formant respectivement l'anode (15) et la cathode (16) du filament LED (1) dépassant de ladite enveloppe (14), lesdites électrodes (15, 16) étant fixées respectivement aux deux extrémités opposées du substrat (10) et étant respectivement connectées électriquement aux première et dernière diodes placées sur le substrat (10), dans lequel ledit contenant externe (3) forme une pièce creuse et longiligne pourvue de deux extrémités (31) opposées, et dans lequel les filaments LED (1) sont répartis selon au moins une ligne d'éclairage, où la ou chaque ligne d'éclairage comprend plusieurs filaments LED (1) disposés en alignement les uns à la suite des autres, ledit dispositif d'éclairage (2) étant **caractérisé en ce que**, dans la ou chaque ligne d'éclairage, les filaments LED (1) sont connectés en parallèle de sorte que leurs anodes (15) sont connectées à la borne de sortie anode (50) et leurs cathodes sont connectées à la borne de sortie cathode (40), et **en ce que** ledit dispositif d'éclairage (2) comprend en outre au moins un réflecteur (8) opaque, présentant une surface interne réfléchissante, disposé sur un pourtour du contenant externe (3) et présentant une fente longitudinale (80) prévue pour le passage de la lumière émise par les filaments LED (1).

2. Dispositif d'éclairage (2) selon la revendication 1, dans lequel le ou chaque réflecteur (8) présente une section transversale en arc de cercle dont le centre est localisé sensiblement sur une ligne d'éclairage, de sorte qu'il forme, en situation d'éclairage, une cavité résonnante qui renvoie dans l'enveloppes d'au moins un filament LED (1) de multiples fois le flux d'éclairage.

3. Dispositif d'éclairage (2) selon les revendications 1 ou 2, dans lequel le réflecteur (8) se présente sous la forme d'un élément réfléchissant monté autour du contenant externe (3) c'est-à-dire sur un pourtour externe du contenant externe (3), ou monté à l'intérieur du contenant externe (3) c'est-à-dire sur un pourtour interne du contenant externe (3).

4. Dispositif d'éclairage (2) selon les revendications 1 ou 2, dans lequel le réflecteur (8) se présente sous la forme d'une couche réfléchissante déposée sur un pourtour externe du contenant externe (3) ou sur un pourtour interne du contenant externe (3).

5. Dispositif d'éclairage (2) selon l'une quelconque des revendications 1 à 4, dans lequel le réflecteur (8) s'étend sur un secteur d'angle au moins supérieur à 200°.

6. Dispositif d'éclairage (2) selon l'une quelconque des revendications 1 à 5, comprenant en outre une optique disposée au moins partiellement en regard de la fente (80) du réflecteur (8), de sorte que le flux de lumière sortant de ladite fente (80) passe par cette optique.

7. Dispositif d'éclairage (2) selon la revendication 6, comprenant un élément d'optique (62) monté sur le contenant externe (3), ledit élément d'optique (62) présentant une section transversale en arc de cercle et comprenant deux parties latérales (63) verrouillées sur le contenant externe (3) et une partie centrale (64) formant l'optique disposée au moins partiellement en regard de la fente (80) du réflecteur (8).

8. Dispositif d'éclairage (2) selon la revendication 6, dans lequel l'optique, disposée au moins partiellement en regard de la fente (80) du réflecteur (8), est réalisée sous la forme d'un revêtement rapporté sur le contenant externe (3) ou d'un traitement réalisé dans la matière constitutive du contenant externe (3), notamment par gravure.

9. Dispositif d'éclairage (2) selon l'une quelconque des revendications 6 à 8, dans lequel l'optique est une optique de focalisation, convergence ou divergence du flux de lumière sortant de la fente (80) du réflecteur (8), ou une optique de filtrage du flux de lumière sortant de la fente (80) du réflecteur (8) de type filtrage opalisant, opalescent, sablé, micro lenticullaire ou micro prismique.

10. Dispositif d'éclairage (2) selon l'une quelconque des revendications 1 à 9, dans lequel la ou chaque ligne d'éclairage comprend un support longiligne, de préférence transparent, présentant sur sa surface au moins un circuit imprimé qui assure la connexion entre la borne de sortie cathode (40) et les cathodes des filaments LED (1), et également la connexion entre la borne de sortie anode (50) et les anodes des filaments LED (1).

11. Dispositif d'éclairage (2) selon l'une quelconque des revendications précédentes, comprenant au moins deux lignes d'éclairage en décalage longitudinal de sorte que les filaments LED (1) d'une ligne d'éclairage sont placés en chevauchement vis-à-vis de deux filaments LED (1) d'une autre ligne d'éclairage.

12. Dispositif d'éclairage (2) selon l'une quelconque des revendications précédentes, dans lequel le contenant externe (3) est constitué d'un tube creux rigide et transparent, notamment de section transversale circulaire, recevant intégralement la ou les lignes d'éclairage.

13. Dispositif d'éclairage (2) selon l'une quelconque des revendications 1 à 11, dans lequel le contenant externe (3) est constitué de plusieurs tronçons tubulaires (30) creux rigides et transparents, ces tronçons tubulaires (30) étant joints bout à bout par des ponts élastiquement déformable (33), où le dispositif d'éclairage (2) comprend une unique ligne d'éclairage, et le contenant externe (3) intègre autant de tronçons tubulaires (30) que la ligne d'éclairage comprend de filaments LED (1), chaque tronçon tubulaire (30) entourant un unique filament LED (1), chaque tronçon tubulaire (30) supportant à ses extrémités (32) respectives des bornes de connexion (43, 53) entre les cathodes (16) et les anodes (15) des filaments LED (1) qui sont entourées par les ponts élastiquement déformable (33).

14. Installation d'éclairage comprenant un chaînage d'au moins deux dispositifs d'éclairage conformes à l'une quelconque des revendications précédentes et joints bout à bout, dans laquelle chaque dispositif d'éclairage (2) comprend deux bornes de sortie anode interconnectées et disposées aux deux extrémités respectives du contenant externe (3) et deux bornes de sortie cathode interconnectées et disposées aux deux extrémités respectives du contenant externe (3), où les dispositifs d'éclairage sont connectés électriquement en parallèle avec une borne de sortie anode (50) et une borne de sorte cathode d'un dispositif d'éclairage (2) connectées respectivement à une borne de sortie anode (50) et une borne de sorte cathode d'un dispositif d'éclairage (2) adjacent.

15. Installation d'éclairage selon la revendication 14, dans lequel une extrémité du contenant externe (3) d'au moins un dispositif d'éclairage (2) est jointe à une extrémité du contenant externe (3) d'au moins un dispositif d'éclairage (2) adjacent au moyen d'une élément de jonction souple qui enveloppe les bornes de sortie concernées des deux dits dispositifs d'éclairage adjacents.

## Patentansprüche

1. Beleuchtungsvorrichtung (2), mehrere LED-Filamente (1) umfassend, die im Inneren eines mindestens teilweise transparenten externen Behälters (3) angeordnet sind, und an Anoden- und Kathodenausgangsklemmen (40, 50; 43, 53) angeschlossen sind, die außerhalb des externen Behälters (3) angeordnet sind, wobei jedes LED-Filament (1) ein längliches Substrat (10) umfasst, eine Vielzahl von Leuchtdioden (11, 12), die regelmäßig in Linie auf dem Substrat (10) verteilt sind, wobei die Dioden (11, 12) sequenziell nacheinander und in Reihe angeschlossen sind, eine um die Dioden (11, 12) und das Substrat (10) umspritzte Hülle (14), und zwei Metallelektroden, die jeweils die Anode (15) und die Kathode (16) des LED-Filaments (1) bilden, die aus der Hülle (14) hervorstehen, wobei die Elektroden (15, 16) jeweils an den beiden entgegengesetzten Enden des Substrats (10) befestigt sind und jeweils elektrisch an die erste und letzte Diode angeschlossen sind, die auf dem Substrat (10) platziert sind, wobei der externe Behälter (3) ein hohles und längliches Teil bildet, das mit zwei entgegengesetzten Enden (31) versehen ist, und wobei die LED-Filamente (1) entlang mindestens einer Beleuchtungslinie verteilt sind, wo die oder jede Beleuchtungslinie mehrere LED-Filamente (1) umfasst, die in Aneinanderreihung nacheinander angeordnet sind, wobei die Beleuchtungsvorrichtung (2) **dadurch gekennzeichnet ist, dass** die LED-Filamente (1) in der oder jeder Beleuchtungslinie derart parallel angeschlossen sind, dass deren Anoden (15) an die Anodenausgangsklemme (50) angeschlossen sind, und deren Kathoden an die Kathodenausgangsklemme (40) angeschlossen sind, und dadurch, dass die Beleuchtungsvorrichtung (2) weiter mindestens einen opaken Reflektor (8) umfasst, der eine reflektierende innere Oberfläche aufweist, der an einem Umfang des externen Behälters (3) angeordnet ist, und einen länglichen Spalt (80) aufweist, der zum Durchgang des durch die die LED-Filamente (1) emittierten Lichts vorgesehen ist.

2. Beleuchtungsvorrichtung (2) nach Anspruch 1, wobei der oder jeder Reflektor (8) einen kreisbogenförmigen Querschnitt aufweist, dessen Zentrum sich im Wesentlichen auf einer Beleuchtungslinie befindet, sodass er in der Beleuchtungssituation eine Resonanzkavität bildet, die in die Hüllen mindestens eines LED-Filaments (1) mehrmals die Beleuchtungsströmung zurückschickt.

3. Beleuchtungsvorrichtung (2) nach den Ansprüchen 1 oder 2, wobei sich der Reflektor (8) in der Form eines reflektierenden Elements präsentiert, der um den externen Behälter (3), das heißt auf einem externen Umfang des externen Behälters (3) montiert ist, oder im Inneren des externen Behälters (3), das heißt auf einem inneren Umfang des externen Behälters (3) montiert ist.

4. Beleuchtungsvorrichtung (2) nach den Ansprüchen 1 oder 2, wobei sich der Reflektor (8) in der Form einer reflektierenden Schicht präsentiert, die auf einem externen Umfang des externen Behälters (3) oder auf einem inneren Umfang des externen Behälters (3) abgeschieden ist.

5. Beleuchtungsvorrichtung (2) nach einem der Ansprüche 1 bis 4, wobei sich der Reflektor (8) auf einem Winkelsektor mindestens größer als 200° erstreckt.

6. Beleuchtungsvorrichtung (2) nach einem der Ansprüche 1 bis 5, weiter eine Optik umfassend, die mindestens teilweise gegenüber dem Spalt (80) des Reflektors (8) angeordnet ist, sodass die Lichtströmung, die aus dem Spalt (80) austritt, durch diese Optik hindurchläuft.

7. Beleuchtungsvorrichtung (2) nach Anspruch 6, ein Optikelement (62) umfassend, das auf dem externen Behälter (3) montiert ist, wobei das Optikelement (62) einen kreisbogenförmigen Querschnitt aufweist, und zwei Seitenteile (63) umfasst, die auf dem externen Behälter (3) verriegelt sind, und ein Mittelteil (64), das die Optik bildet, die mindestens teilweise gegenüber dem Spalt (80) des Reflektors (8) angeordnet ist.

8. Beleuchtungsvorrichtung (2) nach Anspruch 6, wobei die Optik, die mindestens teilweise gegenüber dem Spalt (80) des Reflektors (8) angeordnet ist, in Form einer beigebrachten Beschichtung auf dem externen Behälter (3) oder einer Behandlung realisiert ist, die aus dem Material, aus dem der externe Behälter (3) besteht, insbesondere durch Gravur, realisiert ist.

9. Beleuchtungsvorrichtung (2) nach einem der Ansprüche 6 bis 8, wobei die Optik eine Fokussier-, Konvergenz- oder Divergenzoptik der Lichtströmung ist, die aus dem Spalt (80) des Reflektors (8) austritt, oder eine Filteroptik der Lichtströmung, die aus dem Spalt (80) des Reflektors (8) austritt, in der Art einer opalisierenden, opaleszenten, sandgestrahlten, mikrolinsenförmigen oder mikroprismatischen Filterung ist.

10. Beleuchtungsvorrichtung (2) nach einem der Ansprüche 1 bis 9, wobei die oder jede Beleuchtungslinie einen länglichen, vorzugsweise transparenten Support umfasst, der auf seiner Oberfläche mindestens einen gedruckten Schaltkreis aufweist, der für den Anschluss zwischen der Kathodenausgangsklemme (40) und den Kathoden der LED-Filamente (1) sorgt, und auch für den Anschluss zwischen der Anodenausgangsklemme (50) und den Anoden der LED-Filamente (1).

11. Beleuchtungsvorrichtung (2) nach einem der vorstehenden Ansprüche, mindestens zwei längs versetzte Beleuchtungslinien umfassend, sodass die LED-Filamente (1) einer Beleuchtungslinie in Überschneidung gegenüber von zwei LED-Filamenten (1) einer anderen Beleuchtungslinie platziert sind.

12. Beleuchtungsvorrichtung (2) nach einem der vorstehenden Ansprüche, wobei der externe Behälter (3) aus einem starren und transparenten hohlen Rohr, insbesondere mit einem kreisförmigen Querschnitt gebildet wird, der die Beleuchtungslinie oder Beleuchtungslinien vollständig aufnimmt.

13. Beleuchtungsvorrichtung (2) nach einem der Ansprüche 1 bis 11, wobei der externe Behälter (3) aus mehreren hohlen, starren und transparenten rohrförmigen Abschnitten (30) gebildet wird, wobei diese rohrförmigen Abschnitte (30) auf Stoß durch elastisch verformbare Brücken (33) aneinander angefügt werden, wo die Beleuchtungsvorrichtung (2) eine einzige Beleuchtungslinie umfasst, und der externe Behälter (3) ebenso viele rohrförmige Abschnitte (30) integriert, wie die Beleuchtungslinie an LED-Filamenten (1) umfasst, wobei jeder rohrförmige Abschnitt (30) ein einzelnes LED-Filament (1) umgibt, wobei jeder rohrförmige Abschnitt (30) an seinen jeweiligen Enden (32) Anschlussklemmen (43, 53) zwischen den Kathoden (16) und den Anoden (15) der LED-Filamente (1) trägt, die durch die elastisch verformbaren Brücken (33) umgeben sind.

14. Beleuchtungsinstallation, eine Verkettung von mindestens zwei Beleuchtungsvorrichtungen nach einem der vorstehenden Ansprüche umfassend, und auf Stoß an einander angefügt, wobei jede Beleuchtungsvorrichtung (2) zwei Anodenausgangsklemmen umfasst, die aneinander angeschlossen, und an den beiden jeweiligen Enden des externen Behälters (3) angeordnet sind, und zwei Kathodenausgangsklemmen, die aneinander angeschlossen, und an den beiden jeweiligen Enden des externen Behälters (3) angeordnet sind, wo die Beleuchtungsvorrichtungen elektrisch parallel an eine Anodenausgangsklemme (50) und eine Kathodenausgangsklemme einer Beleuchtungsvorrichtung (2) angeschlossen sind, die jeweils an eine Anodenausgangsklemme (50) und eine Kathodenausgangsklemme einer angrenzenden Beleuchtungsvorrichtung (2) angeschlossen sind.

15. Beleuchtungsinstallation nach Anspruch 14, wobei ein Ende des externen Behälters (3) mindestens einer Beleuchtungsvorrichtung (2) mit einem Ende des externen Behälters (3) mindestens einer angrenzenden Beleuchtungsvorrichtung (2) anhand eines flexiblen Verbindungselements verbunden ist, die die betroffenen Ausgangsklemmen der beiden angrenzenden Beleuchtungsvorrichtungen umhüllt.

## Claims

1. A lighting device (2) comprising several LED filaments (1) disposed inside an outer container (3) at least partially transparent and connected to anode and cathode output terminals (40, 50; 43, 53) disposed outside the outer container (3), each LED filament (1) comprising a longilineal substrate (10), a plurality of light-emitting diodes (11, 12) regularly distributed in line on the substrate (10), said diodes (11, 12) being connected successively in sequence and in series, an envelope (14) overmolded around the diodes (11, 12) and the substrate (10), and two metal electrodes forming respectively the anode (15) and the cathode (16) of the LED filament (1) projecting from said envelope (14), said electrodes (15, 16) being fastened respectively to the two opposite ends of the substrate (10) and being electrically connected respectively to the first and last diodes placed on the substrate (10), wherein the outer container (3) forms a hollow and longilineal part provided with two opposite ends (31), and wherein the LED filaments (1) are distributed along at least one lighting line, wherein the or each lighting line comprises several LED filaments (1) disposed in successive alignment,), said lighting device (2) being **characterized in that**, in the or each lighting line, the LED filaments (1) are connected in parallel such that their anodes (15) are connected to the anode output terminal (50) and their cathodes are connected to the cathode output terminal (40), and **in that** said lighting device (2) further comprises at least one opaque reflector (8), having a reflective inner surface, disposed on a circumference of the outer container (3) and having a longitudinal slot (80) provided for the passage of the light emitted by the LED filaments (1).

2. The lighting device (2) according to claim 1, wherein the or each reflector (8) has an arc-shaped cross-section, whose center is substantially located on a lighting line, such that it forms, in the lighting situation, a resonant cavity which returns multiple times the lighting flux into the envelopes of at least one LED filament (1).

3. The lighting device (2) according to claims 1 or 2, wherein the reflector (8) is in the form of a reflective member mounted around the outer container (3) that is to say on an outer circumference of the outer container (3), or mounted inside the outer container (3) that is to say on an inner circumference of the outer container (3).

4. The lighting device (2) according to claim 1 or 2, wherein the reflector (8) is in the form of a reflective layer deposited on an outer circumference of the outer container (3) or on an inner circumference of the outer container (3).

5. The lighting device (2) according to any one of claims 1 to 4, wherein the reflector (8) extends over an angle sector at least greater than 200°.

6. The lighting device (2) according to any one of claims 1 to 5, further comprising an optic disposed at least partially opposite to the slot (80) of the reflector (80), so that the light flux coming out of said slot (80) passes through this optic.

7. The lighting device (2) according to claim 6, comprising an optical member (62) mounted on the outer container (3), said optical member (62) having an arc-shaped cross-section and comprising two lateral portions (63) locked on the outer container (3) and a central portion (64) forming the optic disposed at least partially opposite to the slot (80) of the reflector (8).

8. The lighting device (2) according to claim 6, wherein the optic, disposed at least partially opposite to the slot (80) of the reflector (8), is made in the form of a coating attached on the outer container (3) or of a processing carried out in the constituent material of the outer container (3), in particular by etching.

9. The lighting device (2) according to any one of claim 6 to 8, wherein the optic is a focusing, convergence or divergence optic of the light flux coming out of the slot (80) of the reflector (8), or a filtering optic of the light flux coming out of the slot (80) of the reflector (8) of the opacifying, opalescent, sandblasted, micro lenticular or micro prismatic filtering type.

10. The lighting device according to any one of claim 1 to 9, wherein the or each lighting line comprises a longilineal support, preferably transparent, having on its surface at least one printed circuit which ensures connection between the cathode output terminal (40) and the cathodes of the LED filaments (1), and also the connection between the anode output terminal (50) and the anodes of the LED filaments (1).

11. The lighting device (2) according to any one of the preceding claims, comprising at least two longitudinally shifted lighting lines such that the LED filaments (1) of a lighting line are placed in overlapping towards two LED filaments (1) of another lighting line.

12. The lighting device (2) according to any one of the preceding claims, wherein the outer container (3) is constituted of a rigid and transparent hollow tube, in particular of a circular cross-section, integrally receiving the lighting line(s).

13. The lighting device (2) according to any one of claims 1 to 11, wherein the outer container (3) is constituted of several rigid and transparent hollow tubular segments (30), these tubular segments (30) being joined end-to-end by elastically deformable bridges (33), where the lighting device (2) comprises a single lighting line, and the outer container (3) integrates as many tubular segments (30) as the lighting line comprises of LED filaments (1), each tubular segment (30) surrounding a single LED filament (1), each tubular segment (30) supporting at its respective ends (32) connection terminals (43, 53) between the cathodes (16) and the anodes (15) of the LED filaments (1) which are surrounded by the elastically deformable bridges (33).

14. A lighting installation comprising a chaining of at least two lighting devices in accordance with any one of the preceding claims and joined end-to-end, in which each lighting device (2) comprises two anode output terminals interconnected and disposed at the two respective ends of the outer container (3) and two cathode output terminals interconnected and disposed at the two respective ends of the outer container (3), in which the lighting devices are electrically connected in parallel with an anode output terminal (50) and a cathode output terminal of a lighting device (2) connected respectively to an anode output terminal (50) and a cathode output terminal of an adjacent lighting device (2).

15. The lighting installation according to claim 14, wherein one end of the outer container (3) of at least one lighting device (2) is joined to one end of the outer container (3) of at least one adjacent lighting device (2) by means of a flexible junction member which envelopes the concerned output terminals of the two said adjacent lighting devices.
